# EUROPÄISCHE PATENTANMELDUNG

(11) **EP 1 833 239 A1**
(43) Veröffentlichungstag der Anmeldung: **12.09.2007**
(21) Anmeldenummer: 07003561.3
(22) Anmeldetag: 21.02.2007
(51) Int. Cl.: H04N 5/04, H03L 7/08

(54) **Verfahren und Schaltung zum zellenverkoppelten Erzeugen eines Taktes**

(30) Priorität: 08.03.2006 DE 10611126
(71) Anmelder: Micronas GmbH, 79108 Freiburg i. Br. (DE)
(72) Erfinder: Waldner, Markus, 9020 Klagenfurt (AT)
(74) Vertreter: Göhring, Robert

(57) **Zusammenfassung**

Die Erfindung bezieht sich auf ein Verfahren bzw. eine entsprechend ausgestaltete Schaltung zum zeilenverkoppelten Erzeugen eines Takts (t), bei dem der Takt (t) in Relation zu einem Synchronisationssignal (hs) bereitgestellt wird und der Takt (t) mittels einer Regelschleife (FLL) bezüglich der Phase und/oder Frequenz in Relation zu dem Synchronisationssignal (hs) geregelt wird, wobei eine Vielzahl (n) von zumindest zwei Zählwerten (cn, c0 - c7) bestimmt wird, wobei jeder der Zählwerte (cn, c0 - c7) über zumindest eine Zähldaueranzahl (z) aufeinanderfolgender Perioden des Synchronisationssignals (hs) bestimmt wird und wobei jeder der Zählwerte (cn, c0 - c7) relativ zu zumindest einem weiteren der Zählwerte (cn, c0 - c7) um einen Zählversatz (v) ungleich der Zähldaueranzahl aufeinanderfolgender Perioden des Synchronisationssignals (hs) zeitlich versetzt bestimmt wird.

## Beschreibung

Die Erfindung bezieht sich auf ein Verfahren zum zeilenverkoppelten Erzeugen eines Taktes gemäß den oberbegrifflichen Merkmalen des Patentanspruches 1 bzw. auf eine Schaltung zum zeilenverkoppelten Erzeugen eines Taktes gemäß den oberbegrifflichen Merkmalen des Patentanspruchs 12.

Das zeilenverkoppelte Erzeugen eines Taktes ist insbesondere für Bild- bzw. Video-ICs (IC: Integrated Circuit / Integrierte Schaltungsanordnung) wichtig, wobei beim Takterzeugen eine phasenstabile Regelschleife eingesetzt wird. Sehr oft werden im Front-End von digitalen Video-ICs zeilenverkoppelte Takte benötigt, welche mit einer so hohen Phasengenauigkeit generiert werden müssen, dass die Phasenabweichung des erzeugten Taktes über eine Bildzeile hinweg nur wenige Prozent der Taktperiode beträgt.

Üblicherweise wird zur Takterzeugung eine digitale PLL (Phase Locked Loop / Phasengekoppelte Schleife) verwendet. Über eine dabei durchgeführte Phasenmessung wird immer die Phase des erzeugten Taktes relativ zum aktuellen horizontalen Synchronisations-Impuls betrachtet. Dadurch kann die Phasenabweichung direkt und die daraus resultierende Frequenzabweichung indirekt bestimmt und ausgeregelt werden. Ein Vorteil einer solchen Verfahrensweise ist die extrem hohe Genauigkeit.

Eine solche Phasenmessung hat jedoch auch Nachteile. Um einen Phasenwert zu messen, der sich unterhalb der Auflösung des Arbeitstaktes der entsprechenden Schaltungsanordnung befindet, müssen Synchronisationsflanken mit analogen Filtern zur Bandbegrenzung abgeflacht werden, so dass die Synchronisationsflanken sicher beobachtet werden können, um sie anschließend mit AD-Wandlern (AD: Analog-zu-Digital) zu digitalisieren. Für eine solche Verfahrensweise werden analoge Filter und ein AD-Wandler benötigt, wobei mindestens 8 Bit Daten verarbeitet werden können müssen. Außerdem muss die Klemmung der AD-Wandler gut eingestellt werden, damit die Synchronisationsflanke nicht verzerrt wird und es dadurch zu Messfehlern kommt, was wiederum dazu führen kann, dass die Regelung die benötigte Güte nicht erreicht und ein entsprechender Fehler als Jitter im Bild sichtbar wird. Der digitale Hardware-Aufwand der Phasenmessung, um robust gegen Störungen zu sein, ist dementsprechend hoch.

Außerdem ist es so nur möglich, externe analoge Synchronisations-Impulse zu bearbeiten. Soll sich die Regelschleife hingegen auf einen Synchronisations-Impuls einklinken, der ein digitaler Impuls im Inneren des ICs selbst ist, geht die Genauigkeit verloren oder es werden zusätzliche digitale Schaltungen benötigt, um die erforderliche Phaseninformation zu bekommen.

Die Aufgabe der Erfindung besteht darin, ein alternatives Verfahren bzw. eine alternative Schaltung zum zeilenverkoppelten Erzeugen eines Taktes vorzuschlagen. Insbesondere soll dabei eine Phasenmessung nicht erforderlich sein und vorteilhaft auch ein digitaler Impuls bzw. Takt im Inneren der Schaltungsanordnung selber verwendet werden können.

Diese Aufgabe wird durch das Verfahren zum zeilenverkoppelten Erzeugen eines Taktes mit den Merkmalen des Patentanspruchs 1 bzw. durch die Schaltung mit den Merkmalen des Patentanspruchs 12 gelöst.

Vorteilhafte Ausgestaltungen sind Gegenstand abhängiger Ansprüche.

Bevorzugt wird demgemäss ein Verfahren zum zeilenverkoppelten Erzeugen eines Takts, bei dem der Takt in Relation zu einem Synchronisationssignal bereitgestellt wird und der Takt mittels einer Regelschleife bezüglich der Phase und/oder Frequenz in Relation zu dem Synchronisationssignal geregelt wird, wobei eine Vielzahl von zumindest zwei Zählwerten bestimmt wird, wobei jeder der Zählwerte über zumindest eine Zähldaueranzahl aufeinander folgender Perioden des Synchronisationssignals bestimmt wird und wobei jeder der Zählwerte relativ zu zumindest einem weiteren der Zählwerte um einen Zählversatz ungleich der Zähldaueranzahl aufeinander folgender Perioden des Synchronisationssignals zeitlich versetzt bestimmt wird.

Bevorzugt wird demgemäss außerdem eine Schaltung zum zeilenverkoppelten Erzeugen eines Takts mit einer Taktquelle zum Bereitstellen eines Takts in Relation zu einem Synchronisationssignal, einer Regelschleife zum Regeln des Takts bezüglich der Phase und/oder Frequenz in Relation zu dem Synchronisationssignal und einer Vielzahl von zumindest zwei Zählern zum Bestimmen einer entsprechenden Vielzahl von Zählwerten über zumindest eine Zähldaueranzahl aufeinander folgender Perioden des Synchronisationssignals, wobei die Zähler ausgelegt oder angesteuert sind, den Zählwert zumindest eines der Zähler relativ zu zumindest dem Zählwert eines der weiteren der Zähler um einen Zählversatz ungleich der Zähldaueranzahl aufeinander folgender Perioden des Synchronisationssignals zeitlich versetzt zu bestimmen.

Eine solche Verfahrensweise bzw. Schaltung ermöglicht eine zeilenverkoppelte Takterzeugung für Video-ICs mit Hilfe einer phasenstabilen FLL (Frequency Locked Loop / Frequenzgekoppelte Schleife). Mit Hilfe einer sehr einfachen jedoch genügend genauen Frequenzmessung werden die gewünschten Anforderungen zum Bereitstellen eines zeilenverkoppelten Taktes mit ausreichender Genauigkeit erfüllt. Auf einfache Art und Weise wird durch eine gestaffelte Anordnung von Zählern bzw. eine gestaffelte Abfolge von Zählverfahren im Falle einer integrierten Schaltungsanordnung mit einem entsprechenden Steuer-Algorithmus die übliche Phasenmessung durch eine Frequenzmessung ersetzbar.

Diese Verfahrensweise zielt auf den grundsätzlichen Ansatz, dass eigentlich die Frequenz und nicht die Phase geregelt werden soll. Eine phasengekoppelte Regelschleife (PLL) wird im Allgemeinen nur deswegen verwendet, weil sie sehr genau und phasenstabil ist. Mit einer frequenzgekoppelten Schleife wird hingegen im Allgemeinen keine ausreichende Phasenstabilität erzielt und die Frequenz muss sehr lange gemessen werden, um ein halbwegs genaues Ergebnis zu erzielen. Mit Hilfe einer derart gestaffelten Anordnung von Zählern bzw. Zählabläufen wird jedoch auch mit einer digitalen frequenzgekoppelten Regelschleife ein theoretisch beliebig genaues und phasenstabiles Ergebnis erzielbar.

Entsprechend werden vorteilhaft die Werte der verschiedenen Zählwerte miteinander verglichen, um eine Phasenverschiebung zwischen dem Takt und dem Synchronisationssignal zu bestimmen. Die Werte der verschiedenen der Zählwerte werden mit einem Sollwert verglichen, um eine erforderliche Korrektur des Takts bzw. einen Korrekturwert zu bestimmen. Vorzugsweise wird zur Bestimmung einer erforderlichen Korrektur des Takts mittels der Zählwerte eine Taktfrequenz bestimmt und anschließend die derart bestimmte Taktfrequenz mit einem Frequenz-Soll-Wert verglichen.

Bei einer solchen Verfahrensweise bzw. Schaltungsanordnung kann der Takt in vorteilhafter Art und Weise mittels einer eigenständigen Taktquelle innerhalb einer integrierten Schaltungsanordnung oder sonstigen Schaltung erzeugt werden und zu dem extern oder ebenfalls durch eine interne Quelle bereitgestellten Synchronisationssignal synchronisiert werden. Das Synchronisationssignal ist im Fall eines Einsatzes in Verbindung mit einem Video-IC vorzugsweise ein Horizontal-Synchronisationssignal einer Zeilenschaltung für eine Bildverarbeitung.

Auf einfache Art und Weise wird durch eine Regelschleife eine Frequenzmessung durchführbar, welche eine trotzdem ausreichende Genauigkeit bietet. Als die Vielzahl von zumindest zwei Zählwerten wird eine Anzahl geringer einer Gesamtanzahl von Zeilen eines Bildsignals verwendet, um ein schnelles Ansprechen der Regelschleife zu ermöglichen. Als die Anzahl der Zählwerte wird dabei ein Wert von 8 Zählwerten bzw. Zählern besonders bevorzugt. Jedoch können größere Werte, beispielsweise 32 oder 64 ebenfalls eingesetzt werden, um eine Genauigkeit der Verfahrensweise bzw. der Schaltung zu erhöhen.

Die Zähldaueranzahl der Zählwerte ist zweckmäßigerweise ebenfalls kleiner einer Bildpunktanzahl einer Zeile eines Bildsignals gesetzt. Die Zähldaueranzahl entspricht dabei zweckmäßigerweise, jedoch nicht notwendig, der Vielzahl der Zählwerte, das heißt insbesondere besonders bevorzugt einem Wert von 8, 32 oder 64. Die Zähldaueranzahl entspricht somit einer Anzahl von Perioden des Synchronisationssignals, insbesondere Horizontal-Synchronisationssignals, und zugleich der Anzahl von Zählern bzw. Zählwerten. Prinzipiell können jedoch die Anzahl der Zähler und die Anzahl der gezählten Perioden des Synchronisationssignals voneinander abweichen, insbesondere im Verhältnis eines ganzzahligen Vielfachen voneinander abweichen.

Entsprechend ist ein Zählversatz gleich einer Periode des Taktsignals gewählt, so dass pro Periode des Taktsignals ein Zähler bzw. ein Zählwert bereitgestellt wird.

Vorteilhaft ist eine solche Schaltung rein digital umsetzbar. AD-Wandler zum Bereitstellen eines digitalen Signals zu einem analogen Horizontal-Synchronisationssignal für die integrierte Schaltung sind nicht mehr erforderlich. Bei Formaten eines Bildsignals, bei welchen mit einem separaten Synchronisationssignal gearbeitet wird, ist das Synchronisationssignal üblicherweise sowieso nur als 1-Bit-Impuls vorhanden, so dass mit einem Zählversatz gleich 1 gearbeitet werden kann. Insbesondere in einem solchen Fall sind weitere AD-Wandler einsparbar, welche ansonsten solche Synchronisationssignale in das System digital einbringen und mit z. B. 8 Bit darstellen müssten. Dazu gehören Grafikkarten-Signale, Signale einer ITU-Schnittstelle (ITU: International Telecommunication Union) und natürlich Signale interne Synchronisationssignalquellen.

Ein Ausführungsbeispiel wird nachfolgend anhand der Zeichnung näher erläutert. Zur Vermeidung von Wiederholungen werden dabei bevorzugt Verfahrensschritte, Funktionen und Schaltungskomponenten nur anhand einer einzelnen der Figuren beschrieben, wobei entsprechende Bezugszeichen auch in den weiteren Figuren verwendet werden. Es zeigen:
- Fig. 1: schematisch ein Grundprinzip einer Schaltung zur zeilenverkoppelten Takterzeugung für Video-ICs mit Hilfe einer phasenstabilen FLL,
- Fig. 2: eine detailliertere Schaltung,
- Fig. 3: einen beispielhaften PI-Regler (PI: Phasen-Inkrement)
- Fig. 4: eine beispielhafte Zähleranordnung zur Frequenzmessung in einer solchen Schaltung,
- Fig. 5: eine Abfolge von Taktdiagrammen eines Horizontal-Synchronisationssignals und der einzelnen Zählerwerte der Zähler,
- Fig. 6: eine Information eines solchen Messsystems anhand einer Taktanzahl, welche über der Anzahl der Horizontal-Synchronisationsimpulse aufgetragen ist zur Darstellung einer Sprungantwort einer Taktfrequenzmessung, und
- Fig. 7: Taktdiagramme eines Horizontal-Synchronisationssignals, eines Takts der Schaltung, von Zählerwerten sowie von Zählerständen nach beispielhaft acht Zeilen für drei verschiedene Phasenlagen.

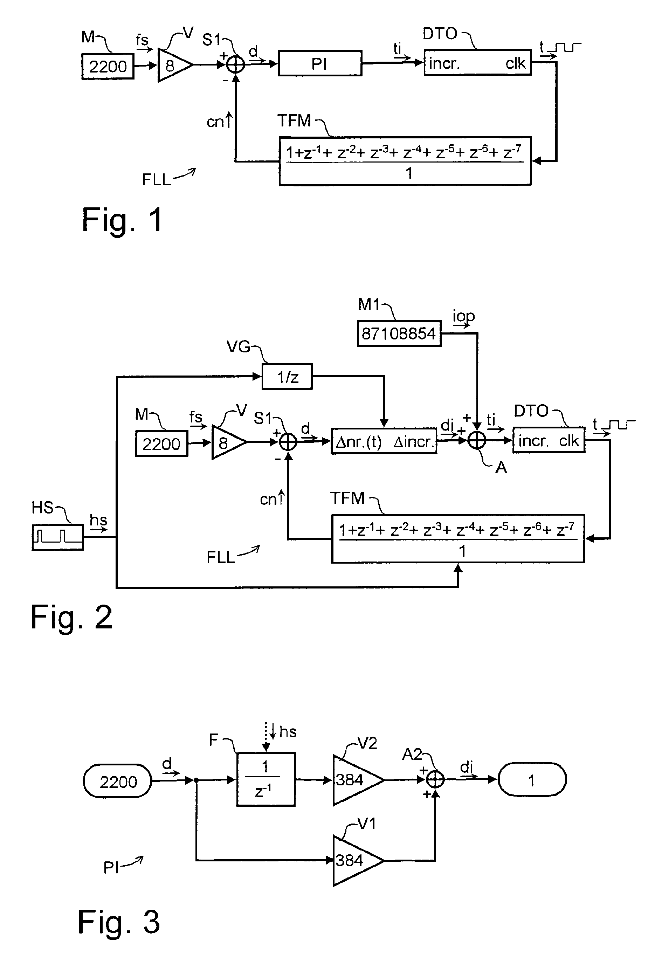

Fig. 1 zeigt schematisch eine beispielhafte Schaltung zum zeilenverkoppelten Erzeugen eines Takts t. Der Takt t wird von einem digitalen Taktoszillator DTO, welcher üblicherweise auch als Digital Timing Oscillator bezeichnet wird, ausgegeben. Der Taktoszillator DTO kann in Form eines Standardelements der Digitaltechnik bereitgestellt werden. Insbesondere kann der Taktoszillator DTO einzeln verwendet oder in eine Regelschleife eingebunden werden. Üblicherweise würde der Taktoszillator in Verbindung mit einer Regelung in Art einer digitalen PLL (Phase Locked Loop) geschaltet werden, wobei jedoch vorliegend eine Phasenregelung in Form einer FLL (Frequency Locked Loop) eingesetzt wird. Da der Taktoszillator DTO selbst durch eine digitale Schaltung ausgebildet ist, insbesondere durch einen Addierer, welcher mit einem einstellbaren Inkrement Modulo addiert, wobei das meist-signifikante Bit (MSB / Most Signifikant Bit) einen Taktausgang clk treibt, benötigt der Taktoszillator DTO auch einen Basistakt ti. Ein solcher Basistakt ti wird dem Taktoszillator DTO üblicherweise von einer analogen PLL angelegt. Dieser Basistakt ti ist dabei meist sehr viel höher als der vom Taktoszillator DTO erzeugte Takt t, in der Regel mindestens doppelt so groß, so dass der Taktoszillator DTO auch einfach als einstellbarer Taktteiler betrachtet werden kann.

Der am Taktausgang clk des Taktoszillators DTO ausgegebene Takt t wird einer Anordnung oder Verfahrensabfolge zur Taktfrequenzmessung TFM angelegt. Die Anordnung zur Taktfrequenzmessung TFM bildet einen diskreten Filter welcher im mathematischen Bereich der z-Transformierten im Falle von acht Stützpunkten darstellbar ist gemäß 1 + 1z⁻¹ + 1z⁻² + 1z⁻³ + 1z⁻⁴ + 1z⁻⁵ + 1z⁻⁶ + 1z⁻⁷, wobei die Summe durch 1 zu teilen ist. In der algorithmischen oder konstruktiven Umsetzung erfolgt die Berechnung durch eine Bestimmung einer Vielzahl von Zählwerten mittels zueinander gestaffelt angeordneter Zähler. Entsprechend werden von der Anordnung zur Taktfrequenzmessung TFM Zählwerte cn ausgegeben.

Die Zählwerte cn der Anordnung zur Taktfrequenzmessung TFM werden einem ersten Subtraktionsglied S1 an dessen Subtraktionseingang angelegt. An dem weiteren Eingang des Subtraktionsglieds S1 wird eine Soll-Frequenz fs für eine Anzahl von Takten pro Zeile multipliziert mit einem Wert der Vielzahl n der Zählwerte cn angelegt. Gegebenenfalls findet zugleich eine Verstärkung der multiplizierten Soll-Frequenz fs statt. Bei dem dargestellten Ausführungsbeispiel mit acht Zählwerten cn, n = 8, entspricht der Multiplikationsfaktor eben dieser Vielzahl n = 8.

Das Subtraktionsergebnis wird einer PI-Steuereinrichtung PI angelegt, wobei dieser Differenzwert d als Regelgröße für die PI-Steuereinrichtung dient. Ein solcher PI-Regler besteht üblicherweise aus zwei Teilen, einem proportional wirkenden P-Anteil und einem integral wirkenden I-Anteil, wobei diesbezüglich eine handelsübliche Komponente einsetzbar ist. Der PI-Regler PI stellt den Basistakt ti für den digitalen Taktoszillator DTO bereit. Gebildet wird somit eine Frequenz-Regelschleife mit einem vom digitalen Taktoszillator DTO bereitgestellten Takt t, welcher als zeilenverkoppelter Takt t zu einem Synchronisationssignal für insbesondere einen Video-IC einer Schaltung zur Bildverarbeitung bereitstellbar ist.

Fig. 2 zeigt eine detailliertere Ausführungsform einer solchen Schaltungsanordnung. Nachfolgend beschrieben werden lediglich Komponenten, welche zusätzlich zu den anhand Fig. 1 beschriebenen Komponenten dargestellt sind. Kern der Schaltung gemäß Fig. 2 ist wieder eine Frequenz-Regelschleife FLL aus einem digitalen Taktoszillator DTO, welcher den Takt t bereitstellt, einer Anordnung zur Taktfrequenzmessung TFM, welche Zählwerte cn ausgibt, einem Subtraktionsglied S1, welche die Zählwerte cn von einer mit der Vielzahl n multiplizierten bzw. verstärkten Soll-Frequenz fs abzieht, und einer PI-Steuereinrichtung PI, deren Ausgangswert dem digitalen Taktoszillator DTO zugeführt wird.

Der Frequenz-Sollwert fs wird vorzugsweise aus einer Speichereinrichtung M bereitgestellt und einem Verstärker V angelegt, welcher neben einer Verstärkung um beispielsweise einen Faktor 2 auch eine Multiplikation mit der Vielzahl n, insbesondere mit dem Wert 8, durchführt. Der PI-Steuereinrichtung PI wird zusätzlich zu dem Differenzsignal des Subtraktionsglieds S1 ein Synchronisationssignal hs in Form einer Abfolge von Horizontal-Synchronisationsimpulsen einer Synchronisations-Impulsquelle HS angelegt. Zweckmäßigerweise wird zuvor das Synchronisationssignal hs in einem Verzögerungsglied VG um eine Einheitsverzögerung l/z, d.h. um einen Takt, verzögert. Die PI-Steuereinrichtung PI arbeitet somit auf Basis eines verzögerten Synchronisationssignals hs und eines Regelwerts in Form des Differenzwerts d des Subtraktionsglieds S1. Der Differenzwert d entspricht dabei einer Differenzanzahl von Takten zwischen dem multiplizierten Frequenz-Sollwert fs und dem momentanen Zählwert cn. Optional, beispielsweise im Fall einer Schaltung mit einer fest vorgegebenen Anzahl von Zählern, kann anstelle des mit der Vielzahl n multiplizierten Frequenz-Sollwerts fs auch direkt ein entsprechend größer angesetzter Frequenz-Sollwert aus dem Speicher M ausgelesen und dem Subtraktionsglied S1 angelegt werden.

Die PI-Steuereinrichtung PI gibt einen Differenz-Inkrementwert di aus, welcher mittels eines Addierglieds A einem Betriebspunkt-Inkrement iop aufaddiert wird, um den Basistakt ti für den digitalen Taktoszillator DTO bereitzustellen.

Fig. 3 zeigt eine beispielhafte PI-Steuereinrichtung PI, welcher der Differenzwert d als Differenzanzahl von Takten angelegt wird. Beispielhaft kann wieder von einer Vielzahl n = 8 an Zählwerten ausgegangen werden. Die Differenzanzahl der Takte in Form des Differenzwerts d wird sowohl einem Verstärker V1 zur Multiplikation mit beim dargestellten Ausführungsbeispiel einem Wert von 128 als auch einer Komponente F zur Umsetzung einer diskreten Übertragungsfunktion 1/z⁻¹ angelegt. Der Ausgangswert der Komponente F zur Umsetzung einer Übertragungsfunktion, welche einen Abgleich mit dem angelegten Synchronisationssignal hs durchführt, wird einem weiteren Verstärker V2 mit beim dargestellten Ausführungsbeispiel einer Verstärkung von 384 zugeführt. Die Ausgangswerte der beiden Verstärker V1, V2 werden einem weiteren Addierer A2 angelegt, dessen Additionsergebnis dem Δ-Inkrement di entspricht, welches von der PI-Steuereinrichtung PI ausgegeben wird.

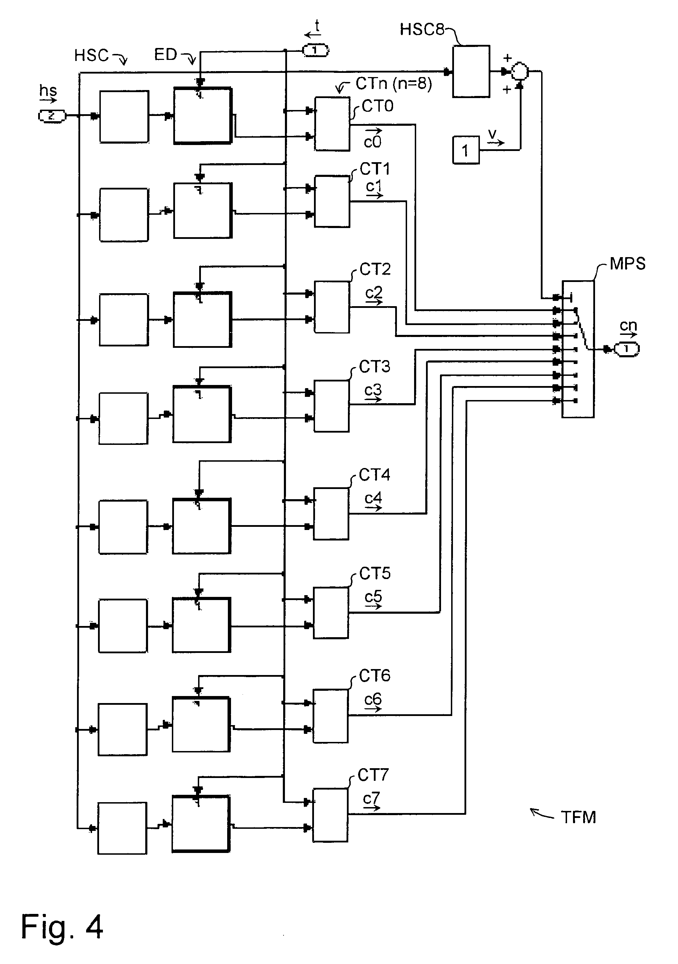

Das Synchronisationssignal hs wird außerdem der Anordnung zur Taktfrequenzmessung TFM angelegt. Ein beispielhafter Aufbau einer solchen Anordnung zur Taktfrequenzmessung TFM ist in Fig. 4 skizziert. Das Synchronisationssignal hs wird einer Vielzahl n = 8 von Synchronisations-Zählern HSC angelegt. Das Synchronisationssignal hs wird dabei jeweils einem Takteingang clk angelegt. Im Fall einer getroffenen Flanke wird von den entsprechenden Synchronisations-Zählern HSC jeweils ein Treffersignal an eine Komponente zur Flanken-Detektion ED angelegt. Der Komponente zur Flanken-Detektion ED liegt als Trigger-Signal außerdem der Takt t an. Im Fall einer erfassten Flanke wird von den Komponenten zur Flanken-Detektion ED jeweils ein Signal und/oder Impuls an einen Synchronisationseingang Hsync eines individuell zugeordneten Zählers CT0 - CT7 einer Gruppe von Zählern CTn angelegt. Außerdem wird jedem der Zähler CT0 - CT7 jeweils der Takt t angelegt. Die Zähler CT0 - CT7 der Gruppe aus Zählern CTn geben jeweils einen Zählwert c1 - c7 aus, das heißt insgesamt 8 Zählwerte cn im Fall einer Anordnung mit einer Vielzahl n = 8 Zählern.

Die Zählwerte CT0 - CT7 werden einem Multiportschalter MPS angelegt, welcher die Zählerwerte cn ausgibt, welche dem Subtraktionsglied S1 angelegt werden. Außerdem wird das Synchronisationssignal hs zusätzlich einem weiteren, neunten Synchronisations-Zähler HSC8 angelegt, welcher eine Abwärtszählung vornimmt und den Wert einem weiteren Addierer A1 anlegt. Der Addierer addiert den Zählwert zu einem vorgegebenen Offset bzw. Versatzwert eines Zählversatzes v und gibt das Additionsergebnis an einen Schalteingang des Multiportschalters MPS aus. Der Zählversatz v dient dazu, das Zählverhältnis der Takte t relativ zu den Impulsen des Synchronisationssignals hs festzulegen, so dass die Zählperiode bzw. die Anzahl der Zähler relativ zu der Anzahl der betrachteten Zeilen variiert werden kann. Beim dargestellten und besonders bevorzugten Ausführungsbeispiel ist der Zählversatz v gleich 1.

Die Anordnung zur Taktfrequenzmessung TFM dient somit dazu, die Anzahl der Takte t, welche von dem Taktoszillator DTO generiert wurden, in Relation zu den Synchronisationssignalen hs, insbesondere in Form horizontaler Synchronisations-Impulse, zu messen. Mit anderen Worten wird bestimmt, wie viele Takte t zwischen zwei Synchronisations-Impulsen bzw. zwischen zwei Perioden des Synchronisationssignals hs auftreten. Die Messung wird dabei umso genauer, je länger sie durchgeführt wird. Bei der beispielhaft dargestellten Anordnung mit einer Vielzahl n von acht Zählern CTn und einem Zählversatz v gleich 1 wird eine Messung über acht Synchronisationssignal-Perioden durchgeführt. Um nicht immer erst nach acht Perioden des Synchronisationssignals hs ein Messergebnis zu erzielen, sind die acht Zähler CTn gestaffelt angeordnet bzw. angesteuert, so dass sie die Zählung jeweils um eine Periode des Synchronisationssignals hs versetzt durchführen.

Der Multiportschalter gibt zyklisch mit jedem Synchronisations-Impuls bzw. mit jeder Periode des Synchronisationssignals hs die aktuelle Taktanzahl der letzten acht Synchronisations-Perioden als Zählwert cn aus, mit welchem dann der Frequenz-Sollwert bzw. der entsprechend multiplizierte Wert verglichen wird. Die Differenz dient dann dem PI-Regler bzw. der PI-Steuereinrichtung als Eingangswert.

Die Synchronisations-Zähler HSC mit den nachfolgenden Komponenten zur Flanken-Detektion ED dienen dabei lediglich als Trigger für die eigentlichen als Taktzähler dienenden Zähler CTn.

Die Taktzähler CTn zählen die Anzahl der Takte t, welche vom digitalen Taktoszillator DTO generiert werden. Im Falle einer Schaltung zur Takterzeugung für einen zeilenverkoppelten Betrieb (Line Locked Mode) eines Video-ICs entsprechen dabei die Takte t jeweils einem Bildpunkt. Entsprechend ist bei einer solchen Anwendung der Zählversatz v zweckmäßigerweise gleich 1 gesetzt. Dadurch wird das abzutastende Bildsignal weder überabgetastet noch unter-abgetastet sondern exakt mit der Bildpunkt-Frequenz abgetastet. Mit dem Takt t des digitalen Taktoszillator DTO können entsprechend der restliche IC zur Bildbearbeitung und damit auch die üblicherweise vorhandenen AD-Wandler betrieben werden.

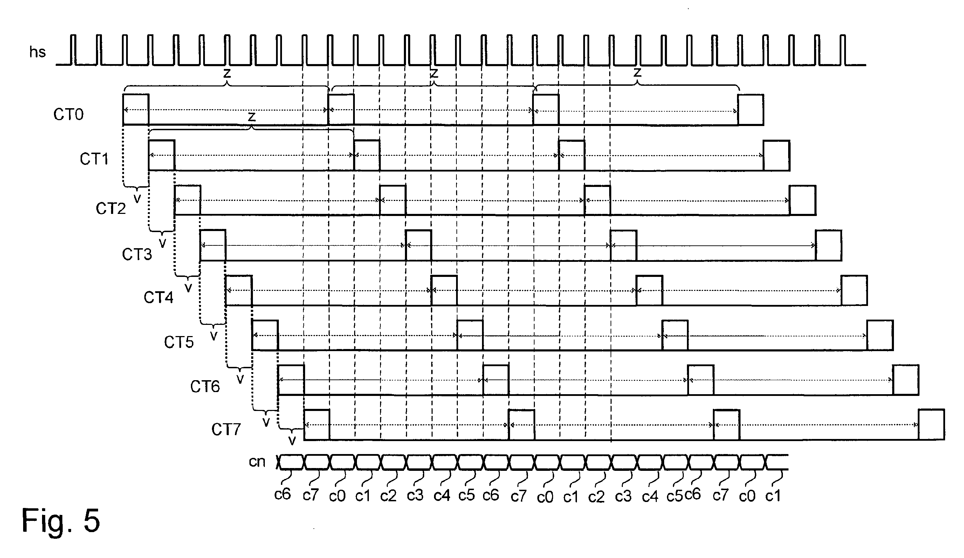

Fig. 5 zeigt beispielhaft eine zeitliche Abfolge von Signalen und Zählwerten der Anordnung zur Taktfrequenzmessung TFM. In der obersten Zeile ist der Verlauf des Synchronisationssignals hs abgebildet. In den darunter liegenden acht Zeilen sind die entsprechenden Reaktionen der einzelnen Zähler CT0 - CT7 der Gruppe aus Zählern CTn abgebildet. Die unterste Zeile zeigt die vom Multiportschalter MPS ausgegebenen Zählwerte cn. Gut erkennbar dargestellt ist, dass jeder der Zähler CT0 - CT7 jeweils während einer ersten Periode des Synchronisationssignals hs schaltet bzw. zählt und dann über eine Dauer der Vielzahl n - 1 einer Zählperiode z den Wert am Ausgang bereitstellt. Die Zählperiode z entspricht dabei im Falle eines Zählversatzes v gleich 1 der Anzahl bzw. Vielzahl n = 8 der Zähler CTn. Die einzelnen der Zähler CT0 - CT7 sind dabei derart angesteuert, dass sie jeweils um den Zählversatz v zueinander versetzt schalten bzw. zählen, so dass ein Ergebnis am Multiportschalter MPS nicht erst nach einer vollständigen Zählperiode z sondern bereits nach der Dauer eines jeden Zählversatzes v anliegt.

Am Multiportschalter MPS wird entsprechend ein jeweils aktueller Zählwert cn ausgegeben, welcher zyklisch über die Anzahl der Takte bzw. im Fall einer Bildverarbeitung die Anzahl der Bildpunkte einer Zeile hochzählt. Entsprechend sind weitere Komponenten und Verfahrensschritte bzw. Funktionen in der Schaltung vorgesehen, wie beispielsweise Komponenten und Funktionen zum Rücksetzen der Zähler CTn zum Ende einer jeweiligen Zeile.

Beispielsweise kann angenommen werden, dass eine Frequenz des Takts t erzielt werden soll, welche pro Zeile nicht ungenauer als ein 8-tel der Taktperiode ist. In diesem Fall muss gemäß dem besonders bevorzugten Ausführungsbeispiel nur über acht Zeilen hinweg die Takte mittels der Vielzahl n von acht Zählern CTn gezählt werden. Außerdem ist die Regelung so aufzubauen, dass die Abweichung aller acht Zeilen auf maximal ± 1 Takt gehalten wird, damit die Bedingung erfüllt ist. Natürlich ist eine solche Regelung, welche nur alle acht Zeilen eingreift, sehr langsam. Mittels der gestaffelt angeordneten Zähler mit einem jeweiligen Zählversatz v gleich der Taktperiode kann diese beschleunigt werden.

Außerdem kann eine Phasenstabilität erreicht werden, da der Takt t zuerst um eine ganze Taktperiode abweichen muss, damit eine schnelle Phasenstabilität zu erzielen, wird mit den acht Zählern CT0 - CT7 jeweils zueinander um den Zählversatz v über eine Periode von acht Zeilen gemessen und dadurch eine gestaffelte Abfolge von Zählwerten cn erzielt.

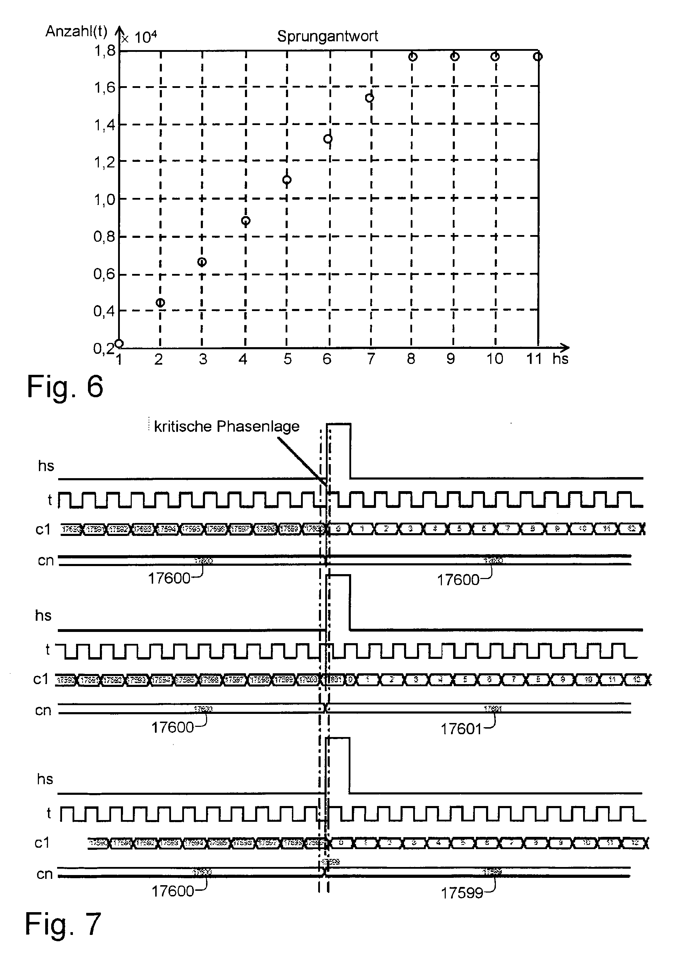

Fig. 6 zeigt eine beispielhafte Sprungantwort des Frequenzmesssystems mit dem Filter bzw. der Anordnung zur Frequenzmessung TFM im Rückkoppelzweig der phasengekoppelten Frequenz-Regelschleife FLL für einen solchen Fall. Aufgetragen ist die Anzahl der Takte t über der Anzahl der Perioden des Synchronisationssignals hs. Bereits nach einer Zähldaueranzahl z von acht Perioden des Synchronisationssignals hs wird ein stabiler Zustand erzielt.

Zu diesem Zeitpunkt sind bei einer typischen Taktanzahl pro Zeile ca. 1,8 × 10⁴ Takte t erzielt. Bei einer Sprungantwort eines solchen Messsystems ist erkennbar, dass natürlich erst nach acht Zeilen die volle Taktanzahl sichtbar ist, aber bereits Zwischenergebnisse geliefert werden. Die Übertragungsfunktion entspricht dabei der Übertragungsfunktion eines FIR-Filters (FIR: Finite Impulse Response). Die Schaltungen gemäß Fig. 1 und Fig. 2 berücksichtigen eine solche Übertragungsfunktion in der geschlossenen Regelschleife.

Erzielt wird somit bei jeder Zeile eine Information darüber, wie genau der Takt t während der letzten n = 8 Zeilen war. Ist der Zählwert cn um den Wert 1 zu groß oder zu klein, kann die Regelung der PI-Steuereinrichtung PI sofort eine Nachregelung bewirken.

Zur Erläuterung der erzielbaren Phasenstabilität wird vorweg angenommen, dass sich das System in einem eingeschwungenen Zustand befindet und alle Zähler CTn, CT0 - CT7, nach acht Zeilen den gleichen Zählerstand bzw. Zählwert c0 - c7 aufweisen. In einem solchen Fall ist es in der physikalischen Realität so, dass die Frequenz nicht genau passt und es zu einer Phasendrift bezogen zum Synchronisationssignal hs kommt. Ist die Phasendrift so weit fortgeschritten, dass ein erster der Zähler CTn, CT0 - CT7 mit seinem Zählwert c0 - c7 um den Wert 1 mehr oder weniger weit zählt als der vorherige der Zähler CTn, beginnt die Regelung, dieser Änderung entgegenzuwirken. Die Regelung bewirkt, dass der Takt t langsamer oder sogar in die entgegengesetzte Richtung zu driften beginnt. Ein solches Verzählen passiert dabei nicht an irgendeiner Stelle, sondern ist abhängig von der Phasenlage zwischen dem Synchronisationssignal hs und dem Takt t, wie dies anhand Fig. 7 skizziert ist. Liegen die steigenden Flanken des Synchronisationssignals hs und des Takts t genau beieinander, kann die Schaltungsanordnung nicht mehr vorhersagen, ob der momentane Takt t noch gezählt wird oder eben nicht mehr gezählt wird. Diese Situation ist in dem oberen der drei Ablaufdiagramme aus Fig. 7 dargestellt. Die oberste Zeile zeigt dabei das Synchronisationssignal hs mit einem einzelnen Impuls, dessen steigende Flanke mit einer steigenden Flanke eines in der Zeile darunter dargestellten Taktes t zeitlich zusammenfällt. In der darunter dargestellten Zeile ist der momentane Zählerstand angegeben. Die vierte Zeile zeigt den Zählerstand nach jeweils acht Zeilen, was der Periode des Impulses des Synchronisationssignals hs beim vorliegenden Beispiel entspricht.

Wenn die Regelung in der entgegengesetzten Richtung zu der vorherigen Phasendrift steuert, passiert der gleiche Vorgang wieder, so dass die Taktphase letztendlich genau bei diesem Übergang hängen bleibt, weil die Regelung um diesen Punkt zu zirkulieren beginnt. Dabei entspricht die Weite der Zirkulation +/- 1 Takt, wenn eine entsprechende Auslegung des PI-Reglers PI vorgenommen ist. Im Gesamten entspricht dies wieder maximal einer 1/8-Taktperiode. Mit anderen Worten muss, um eine Änderung eines Zählers um 1 zu detektieren, nicht mehr eine ganze Taktperiode des Takts t weit gedriftet werden, sondern nur mehr um maximal 1/8 der Periode des Takts t.

Anschaulich ist dies anhand Fig. 7 erkennbar, in welcher der Zählerstand im Fall der kritischen Phasenlage bei identischem Übergang des Synchronisationssignals hs und des Takts t zuvor bei einem Wert von 17.600 liegt und mit dem Synchronisations-Impuls des Synchronisationssignals hs auf 0 rückgesetzt wird. In einem solchen Fall bleibt der momentane Zählerstand, das heißt der vom Multiportschalter MPS ausgegebene Zählerwert cn auch nach dem Schaltvorgang auf einem Wert von 17.600 stehen. In den in der Mitte von Fig. 7 dargestellten Ablaufdiagrammen liegt der Impuls des Synchronisationssignals hs zeitlich etwas hinter der entsprechenden Flanke des Takts t, was zu einem Zählerwert cn von 17.601 und einem verkürzten Intervall mit zurückgesetzten Zählerständen führt. Vom Multiportschalter MPS wird entsprechend nach dem Übergang der beiden Signale ein Zählerwert cn von 17.601 ausgegeben. Bei diesem Diagramm liegt somit der Takt t zeitlich etwas vor dem Synchronisationssignal hs. In der unteren Abfolge von Taktdiagrammen liegt die steigende Flanke des Takts t zeitlich etwas hinter der steigenden Flanke des Synchronisationssignals hs, wobei beide Flanken noch innerhalb der kritischen Phasenlage von 1/8-Taktperiode des Takts t liegen. Dies hat zur Folge, dass der momentane Zählerwert noch beim Wert von 17.599 liegt, so dass nachfolgend vom Multiportschalter MPS der Zählerwert 17.599 als Zählerstand nach acht Zeilen ausgegeben wird.

Auf diesem Grundprinzip aufbauend kann die Vielzahl n der Zähler CTn, die Zähldaueranzahl z der Impulse des Synchronisationssignals hs, über welche pro Zähler einmal gezählt wird, und/oder der Zählversatz v entsprechend der gewünschten Genauigkeit angepasst werden. Zur Erhöhung der Genauigkeit kann die Anzahl bzw. Vielzahl n der Zähler erhöht werden auf beispielsweise 32 oder 64.

## Patentansprüche

1. Verfahren zum zeilenverkoppelten Erzeugen eines Takts (t), bei dem
- der Takt (t) in Relation zu einem Synchronisationssignal (hs) bereitgestellt wird und
- der Takt (t) mittels einer Regelschleife (FLL) bezüglich der Phase und/oder Frequenz in Relation zu dem Synchronisationssignal (hs) geregelt wird,
**dadurch gekennzeichnet , dass**
- eine Vielzahl (n) von zumindest zwei Zählwerten (cn, c0 - c7) bestimmt wird,
- wobei jeder der Zählwerte (cn, c0 - c7) über zumindest eine Zähldaueranzahl (z) aufeinanderfolgender Perioden des Synchronisationssignals (hs) bestimmt wird und
- wobei jeder der Zählwerte (cn, c0 - c7) relativ zu zumindest einem weiteren der Zählwerte (cn, c0 - c7) um einen Zählversatz (v) ungleich der Zähldaueranzahl aufeinanderfolgender Perioden des Synchronisationssignals (hs) zeitlich versetzt bestimmt wird.

2. Verfahren nach Anspruch 1, bei dem die Werte der verschiedenen der Zählwerte (cn, c0 - c7) miteinander verglichen werden zur Bestimmung einer Phasenverschiebung zwischen dem Takt (t) und dem Synchronisationssignal (hs).

3. Verfahren nach Anspruch 1 oder 2, bei dem die Werte der verschiedenen der Zählwerte (cn, c0 - c7) verglichen werden mit einem Sollwert (fs) zur Bestimmung einer erforderlichen Korrektur des Takts (t).

4. Verfahren nach einem vorstehenden Anspruch, bei dem zur Bestimmung einer erforderlichen Korrektur des Takts (t) mittels der Zählwerte (cn, c0 - c7) eine Taktfrequenz (ft) bestimmt wird und bei dem die Taktfrequenz (ft) verglichen wird mit einem Frequenz-Sollwert (fs).

5. Verfahren nach einem vorstehenden Anspruch, bei dem der Takt (t) mittels einer eigenständigen Taktquelle erzeugt und zu dem Synchronisationssignal (hs) synchronisiert bereitgestellt wird.

6. Verfahren nach einem vorstehenden Anspruch, bei dem als das Synchronisationssignal (hs) ein Horizontal-Synchronisationssignal (hs) einer Zeilenschaltung für eine Bildverarbeitung verwendet wird.

7. Verfahren nach einem vorstehenden Anspruch, bei dem die Regelschleife (FLL) eine Frequenzmessung durchführt.

8. Verfahren nach einem vorstehenden Anspruch, bei dem als die Vielzahl (n) von zumindest zwei Zählwerten (cn, c0 - c7) eine Anzahl geringer einer Gesamtanzahl von Zeilen eines Bildsignals verwendet wird.

9. Verfahren nach einem vorstehenden Anspruch, bei dem die Zähldaueranzahl (z) der Zählwerte (cn, c0 - c7) kleiner einer Bildpunktanzahl einer Zeile eines Bildsignals gesetzt wird.

10. Verfahren nach einem vorstehenden Anspruch, bei dem die Zähldaueranzahl (z) der Zählwerte (cn, c0 - c7) gleich der Vielzahl (n) der Zählwerte (cn, c0 - c7) gesetzt wird.

11. Verfahren nach einem vorstehenden Anspruch, bei dem der Zählversatz (v) einer Periode des Taktsignals (t) entspricht.

12. Schaltung zum zeilenverkoppelten Erzeugen eines Takts (t) mit
- einer Taktquelle (DTO) zum Bereitstellen eines Takts (t) in Relation zu einem Synchronisationssignal (hs) und
- einer Regelschleife (FLL) zum Regeln des Takts (t) bezüglich der Phase und/oder Frequenz in Relation zu dem Synchronisationssignal (hs),
**gekennzeichnet durch**
- eine Vielzahl (n) von zumindest zwei Zählern (CTn, CT0 - CT7) zum Bestimmen einer entsprechenden Vielzahl (n) von Zählwerten (cn, c0 - c7) über zumindest eine Zähldaueranzahl (z) aufeinanderfolgender Perioden des Synchronisationssignals (hs),
- wobei die Zähler (CTn, CT0 - CT7) ausgelegt oder angesteuert sind, den Zählwert (cn, c0 - c7) zumindest eines der Zähler (CTn, CT0 - CT7) relativ zu zumindest dem Zählwert (cn, c0 - c7) eines der weiteren der Zähler (CTn, CT0 - CT7) um einen Zählversatz (v) ungleich der Zähldaueranzahl aufeinanderfolgender Perioden des Synchronisationssignals (hs) zeitlich versetzt zu bestimmen.

13. Schaltung nach Anspruch 12 mit einer Bestimmungseinrichtung (PI) zum Vergleichen der Werte der verschiedenen der Zählwerte (cn, c0 - c7) miteinander zur Bestimmung einer Phasenverschiebung zwischen dem Takt (t) und dem Synchronisationssignal (hs).

14. Schaltung nach Anspruch 12 oder 13 mit einer Bestimmungseinrichtung (PI) zum Vergleichen der Werte der verschiedenen der Zählwerte (cn, c0 - c7) mit einem Sollwert (fs) zum Bestimmen einer erforderlichen Korrektur des Takts (t).

15. Schaltung nach einem der Ansprüche 12 bis 14 mit einer Bestimmungseinrichtung (PI, DTO) zum Bestimmen einer Taktfrequenz (ft) mittels der Zählwerte (cn, c0 - c7) und zum Vergleichen der Taktfrequenz (ft) mit einem Frequenz-Sollwert (fs) zum Bestimmen einer erforderlichen Korrektur des Takts (t).

16. Schaltung nach einem der Ansprüche 12 bis 15 als Bildverarbeitungsschaltung zum Bereitstellen des Takts (t) synchronisiert zu dem Synchronisationssignal (hs) als einem Horizontal-Synchronisationssignal (hs) einer Zeilenschaltung.

17. Schaltung nach einem der Ansprüche 12 bis 16, bei der die Regelschleife (FLL) ausgelegt ist zum Durchführen einer Frequenzmessung und / oder einer Frequenzregelung.

18. Schaltung nach einem der Ansprüche 1 bis 17 zum Durchführen eines Verfahrens nach einem der Ansprüche 1 bis 11.
